# EUROPÄISCHE PATENTSCHRIFT

(11) **EP 1 038 343 B1**
(45) Veröffentlichungstag und Bekanntmachung des Hinweises auf die Patenterteilung: **06.06.2007**
(21) Anmeldenummer: 99945974.6
(22) Anmeldetag: 11.08.1999
(51) Int. Cl.: H02B 1/06

(54) **PLOMBIERBARE VERSCHLIESSEINRICHTUNG**
LEAD SEALABLE LOCKING DEVICE
DISPOSITIF DE VERROUILLAGE SCELLABLE

(30) Priorität: 09.10.1998 DE 19846576
(43) Veröffentlichungstag der Anmeldung: 27.09.2000
(73) Patentinhaber: AEG Niederspannungstechnik GmbH & Co. KG, 24534 Neumünster (DE)
(72) Erfinder: HILLEBRAND, Dietmar, D-31848 Bad Münder (DE); PRIES, Jürgen, D-31785 Hameln (DE)
(74) Vertreter: TBK-Patent
(86) Internationale Anmeldenummer: PCT/EP1999/005897
(87) Internationale Veröffentlichungsnummer: WO 2000/022707

(56) Entgegenhaltungen:
- EP-A- 0 509 853
- DE-A- 3 138 042
- DE-U- 8 708 744
- FR-A- 2 579 016
- GB-A- 2 099 631

## Beschreibung

Die vorliegende Erfindung bezieht sich auf eine plombierbare Verschließeinrichtung zur Unzugänglichmachung und Verplombung einer Betätigungseinrichtung für ein elektrisches Gerät wie eine elektrische Anschlußklemme, auf ein elektrisches Gerät wie einen Leistungsschutzschalter oder dergleichen und auf ein System bestehend aus der plombierbaren Verschließeinrichtung und dem elektrischen Gerät.

In elektrischen Geräten wie beispielsweise einem Leistungsschutzschalter sind in der Regel Anschlußklemmen vorgesehen, in denen ein elektrischer Leiter festgeklemmt wird. Eine derartige Klemmstelle besteht normalerweise aus einem Kontaktblech und einer Schraube, wobei das Kontaktblech in der Mitte eine Bohrung aufweist, durch die die Schraube hindurch gesteckt wird und in einen darunter liegenden Gehäuseabschnirt eingeschraubt wird, so daß wenn der elektrische Leiter, wenn er zwischen dem Schraubenkopf und dem elektrischen Kontaktblech eingelegt wird, beim Einschrauben der Schraube zwischen dem Schraubenkopf und dem Kontaktblech festgeklemmt wird.

Bei Geräten, bei denen es entweder vorgeschrieben oder zumindest erwünscht ist, daß unbefugte Personen die Klemmen nicht ohne weiteres und unbemerkt lösen können, wurde bisher eine Plombierung vorgenommen. Dadurch kann sofort nachgeprüft werden, ob die Anschlußklemme manipuliert wurde, da in einem solchen Fall die Verplombung aufgebrochen werden mußte. Es wurde beispielsweise bei einem Leistungsschutzschalter eine Klappe vorgesehen, die gelenkig an dem Leistungsschutzschalter angebracht war, so daß ein Zugang zum Lösen bzw. Fixieren des elektrischen Anschlusses in dem elektrischen Gerät nur im aufgeklappten Zustand möglich war, während im zugeklappten Zustand der Zugang verschlossen war. Nach dem Festklemmen eines elektrischen Leiters an der Klemmstelle wurde die Klappe geschlossen und mit einem herkömmlichen Plombierdraht verplombt.

Diese Lösung setzte zum einen eine aufwendige Klappenkonstruktion voraus, die die Herstellung eines derartigen Leistungsschutzschalters verteuerte. Darüber hinaus war die Handhabung einer derartigen Klappe unkomfortabel.

Derartige plombierbaren Verschließeinrichtungen sind aus der FR-A-2 579 016 und der GB-A-2 099 631 bekannt.

Es ist daher Aufgabe der vorliegenden Erfindung, eine installationsfreundliche und kostengünstige Verplombungseinrichtung an elektrischen Geräten, wie Leistungsschutzschaltern und dergleichen, zu entwickeln.

Diese Aufgabe wird durch die Merkmale der Ansprüche 1, 7 und 14 gelöst.

Durch das Vorsehen einer in eine Einschuböffnung im elektrischen Gerät einschiebbaren plombierbaren Verschließeinrichtung, die zudem mit einer Durchstecköffnung zum Durchstecken eines Plombierdrahtes versehen ist, ist eine einfache, kostengünstige Unzugänglichmachung und Verplombung möglich.

Die Verschiebbarkeit der plombierbaren Verschließeinrichtung in eine geöffnete und eine geschlossene Position, in der der Zugang zum Lösen bzw. Fixieren beispielsweise eines elektrischen Anschlusses wahlweise verdeckt oder freigegeben wird, erlaubt einen bequemen Zugang zu der Klemmstelle und ebenso eine bequeme Abdeckung und Verplombungsmoglichkeit dieser Klemmstelle, da durch einfaches Ein- und Ausschieben der plombierbaren Verschließeinrichtung eine Zugangsöffnung des elektrischen Gerätes, durch die ein Hilfswerkzeug wie ein Schraubendreher oder dergleichen eingeführt werden kann, auf- bzw. zugeschoben wird, um zu der Klemmstelle zu gelangen, um eine Klemmschraube zu lösen bzw. zu fixieren.

Ferner wird das Verplomben vereinfacht, indem eine Durchstecköffnung in der plombierbaren Verschließeinrichtung vorgesehen ist, durch die der Plombierdraht einfach durchgesteckt werden muß. Die Einführung des Plombierdrahtes wird noch weiter vereinfacht, indem ein nutartiger Kanal auf der Oberseite des Einsteckabschnittes vorgesehen ist, der in der Durchstecköffnung endet, so daß der Plombierdraht einfach in die Nut eingeschoben wird und darin geführt wird und anschließend automatisch durch die Durchstecköffnung gleitet. Das Einführen des Plombierdrahtes kann noch weiter vereinfacht werden, indem der nutartige Kanal an seinem Anfang abgeschrägt ist, so daß ein Plombierdraht sicherer in den nutartigen Kanal eingeführt wird.

Um die plombierbare Verschließeinrichtung im eingeschobenen Zustand (d. h. im geschlossenen Zustand, in dem der Zugang zur Klemmstelle des elektrischen Anschlusses verdeckt ist) zu fixieren, ist am Ende des Einsteckabschnittes eine Rastnase ausgebildet, die in einen entsprechenden Einschnappabschnitt im elektrischen Gerät einschnappbar ist.

Vorteilhafterweise ist diese Rastnase mit einem Vorsprung ausgebildet, der flexibel in einen entsprechend ausgebildeten Einschnappabschnitt des elektrischen Gerätes einschnappbar ist, der vorzugsweise eine Hinterschneidung aufweist.

Um dem Einsteckabschnitt der plombierbaren Verschließeinrichtung am Ende die erforderliche Flexibilität zu geben, ist am Endbereich etwa in der Mitte ein Schlitz vorgesehen, so daß die Rastnase beim Einschieben in die Einschuböffnung zunächst etwas zusammengedrückt werden kann, wenn die Abmessung der Einschuböffnung etwas kleiner als der Einsteckabschnitt ist. Wenn die Rastnase in den Hinterschneidungsabschnitt eingreift, wird der vorbelastete Einsteckabschnitt entspannt und die Rastnase schnappt regelrecht in der Hinterschneidung ein und ist somit fixiert. In dieser Position ist das Einführen des Plombierdrahtes einfach, da nicht darauf geachtet werden muß, daß die plombierbare Verschließeinrichtung nicht aus der Einschuböffnung herausfällt, wenn der Plombierdraht in die Durchstecköffnung eingeschoben wird.

Eine weitere vorteilhafte Gestaltung des Erfindungsgegenstandes liegt darin, daß die plombierbare Verschließeinrichtung mit mindestens einem Klemmsteg versehen ist, der senkrecht zur Einschubrichtung vorsteht. Dieser Klemmsteg dient dazu, beim Herausziehen der plombierbaren Verschließeinrichtung in eine quer zur Einschubrichtung vorgesehene Nut, die am Einschubabschnitt im elektrischen Gerät vorgesehen ist, einzurasten, so daß folgende Vorteile erreicht werden:

Durch die verrastete Stellung der plombierbaren Verschließeinrichtung kann die plombierbare Verschließeinrichtung nicht aus der Einschuböffnung herausfallen, da der Klemmsteg beim Zurückziehen der plombierbaren Verschließeinrichtung in die Nut einrastet. Außerdem kann befugtes Personal, das die plombierbare Verschließeinrichtung gebrochen hat, die Klemmschraube der Anschlußklemme lösen, ohne daß die plombierbare Verschließeinrichtung vollständig entfernt werden müßte. Vielmehr muß die plombierbare Verschließeinrichtung lediglich in die herausgezogene Position gebracht werden. Anschließend kann die Kappe einfach wieder eingeschoben werden, so daß der Zugang zu der Klemmschraube von dem Einsteckabschnitt der plombierbaren Verschließeinrichtung wieder abgedeckt wird.

Selbstverständlich muß ein elektrisches Gerät eine entsprechende Einschuböffnung besitzen, die quer zur Einschubrichtung eine Nut ausgebildet hat, in die der Klemmsteg eingreifen kann.

Weitere vorteilhafte Ausgestaltungen und Variationen der vorliegenden Erfindung sind Gegenstand der Unteransprüche.

Die vorliegende Erfindung soll nun anhand einer ausführlichen Beschreibung eines derzeitigen Ausführungsbeispiels unter Bezugnahme auf die beigefügten Zeichnungen näher erläutert werden. Es soll an dieser Stelle jedoch noch einmal betont werden, daß die vorliegende Erfindung nicht auf einen Leistungsschutzschalter beschränkt ist, sondern vielmehr für jede elektrische Anschlußklemme geeignet ist.
Figur 1 ist eine perspektivische Darstellung eines Leistungsschutzschalters mit einer, plombierbaren Verschließeinrichtung und einer Plombe gemäß dem Ausführungsbeispiel der vorliegenden Erfindung.
Figur 2 ist eine perspektivische Ansicht eines elektrischen Gerätes mit einer plombierbaren Verschließeinrichtung ohne eine Plombe.
Figur 3 ist eine perspektivische Einzeldarstellung der plombierbaren Verschließeinrichtung.
Figur 4 ist eine perspektivische Darstellung eines elektrischen Gerätes mit der plombierbaren Verschließeinrichtung, jedoch ohne einen Deckel.
Figur 5 ist eine perspektivische Darstellung des elektrischen Gerätes mit der plombierbaren Verschließeinrichtung in einer herausgezogenen Stellung, wobei der Deckel zum besseren Verständnis zur Hälfte geschnitten dargestellt ist.
Figur 6 ist eine perspektivische, vergrößerte Darstellung aus Figur 5.
Figur 7 ist eine perspektivische Darstellung eines weiteren Ausführungsbeispiels einer plombierbaren Verschließeinrichtung gemäß der vorliegenden Erfindung.

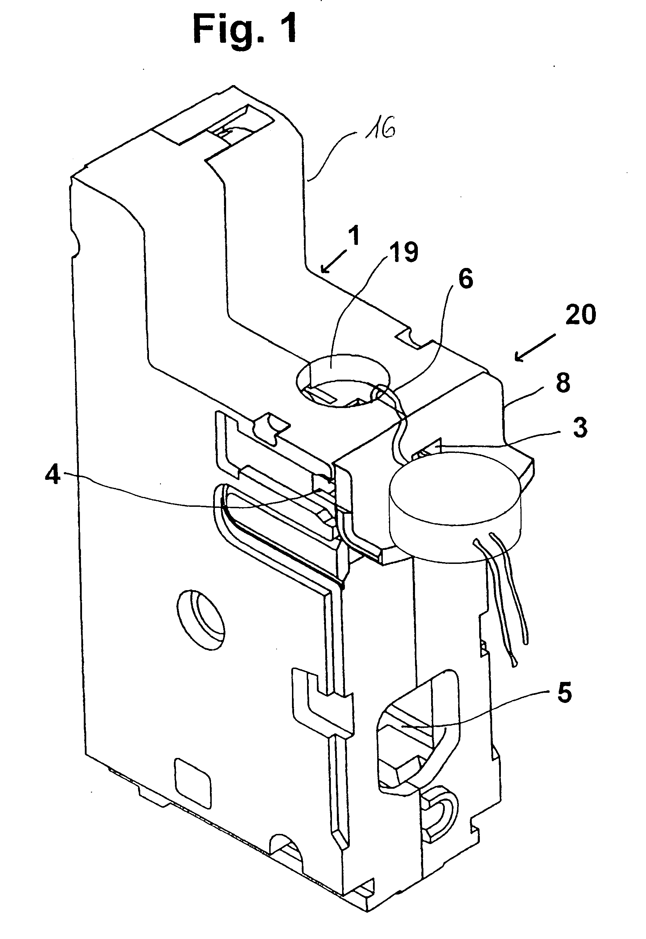

Figur 1 zeigt eine Gesamtdarstellung eines verplombten elektrischen Gerätes. Eine plombierbare Verschließeinrichtung 20 steckt in einer Einschuböffnung 4 des elektrischen Gerätes 1. Ein Plombierdraht 6 ist durch eine Durchstecköffnung 3 durch die plombierbare Verschließeinrichtung 20 gesteckt und umgreift einen Deckel 16 des elektrischen Gerätes 1. Beide Endbereiche des Plombierdrahts 6 sind miteinander verplombt, so daß die plombierbare Verschließeinrichtung 20 nicht mehr aus der Einschuböffnung 4 herausgezogen werden kann, ohne den Plombierdraht bzw. die Plombe zu brechen.

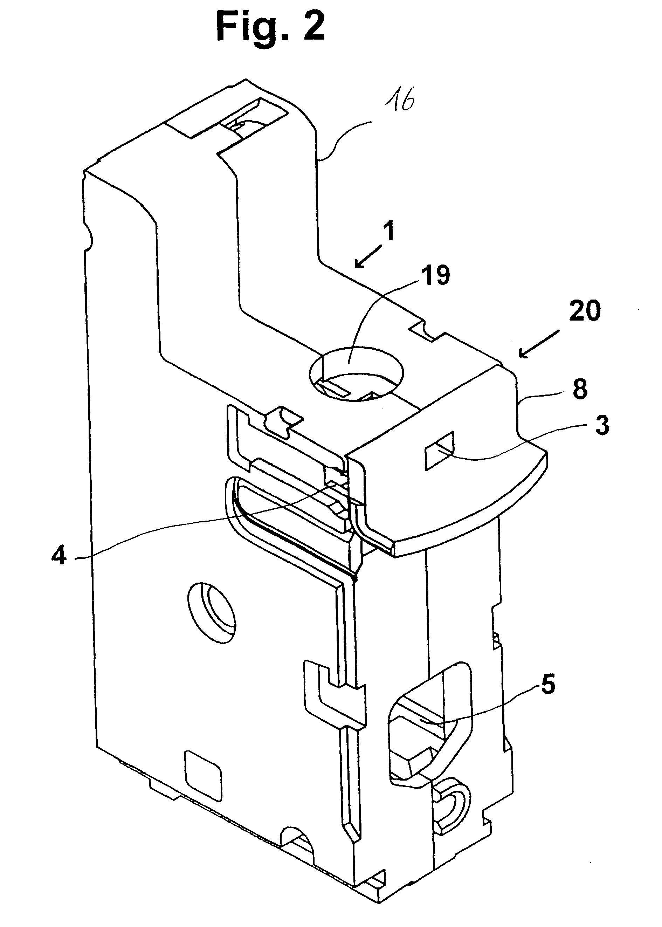

Figur 2 zeigt die gleiche Darstellung wie Figur 1, jedoch ist hier der Plombierdraht und die Plombe weggelassen.

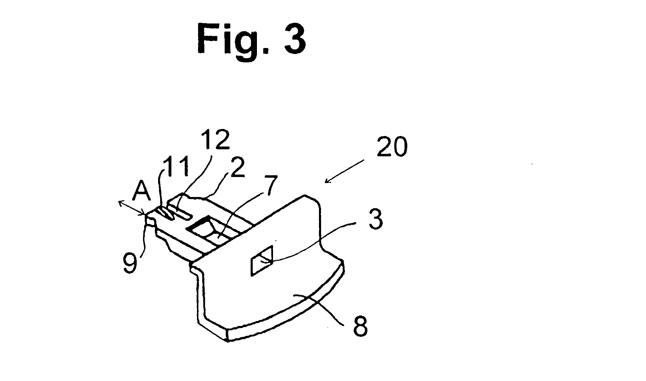

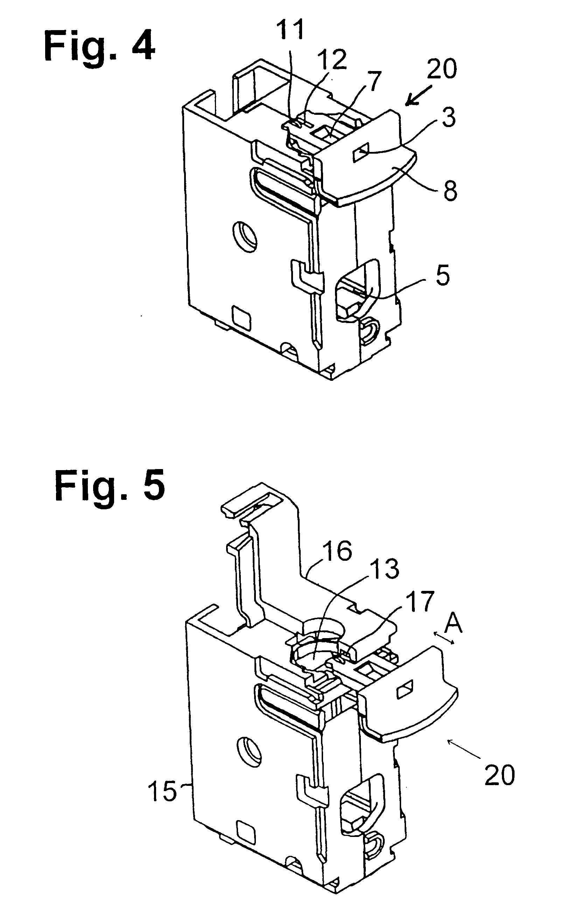

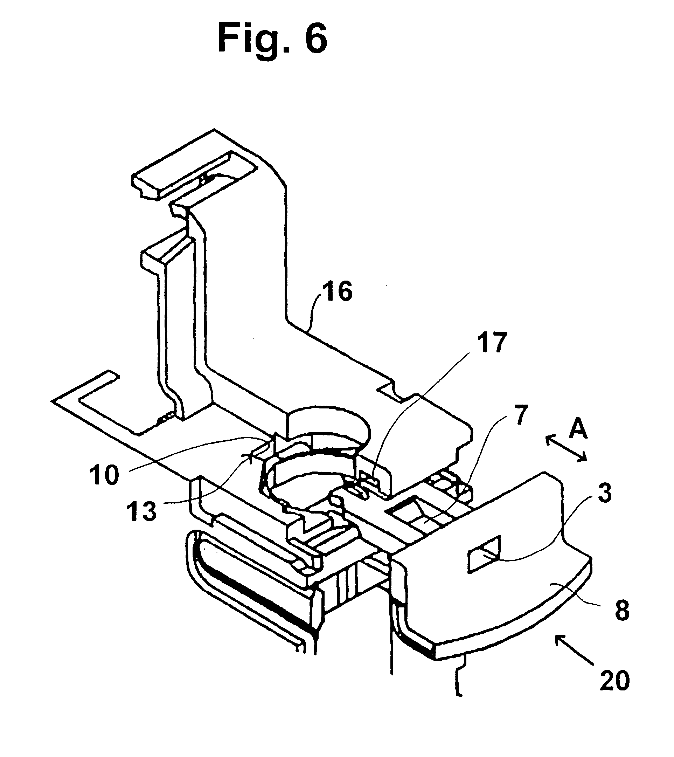

Unter Bezugnahme auf Figur 3 soll nun die plombierbare Verschließeinrichtung näher erläutert werden. Die plombierbare Verschließeinrichtung besteht im wesentlichen aus einem Einsteckabschnitt 2 und einem Anlageabschnitt 8, die sich im wesentlichen rechtwinklig zueinander erstrecken. Der Einsteckabschnitt 2 hat am Ende ein Paar Rastnasen 9 und einen Schlitz 12, der die beiden Rastnasen flexibel macht. Ferner ist am Ende des Einsteckabschnitts 2 ein Klemmsteg 11 vorgesehen, der sich senkrecht nach oben in Figur 3 von dem Einsteckabschnitt erstreckt. Wie in Figur 3 zu erkennen ist, ist der Klemmsteg 11 abgerundet bzw. abgeschrägt, um ein Verschieben der plombierbaren Verschließeinrichtung zu erleichtern. Der Klemmsteg 11 dient nämlich dazu, die plombierbare Verschließeinrichtung gegen Herausfallen zu sichern, falls die plombierbare Verschließeinrichtung in eine geöffnete Position verschoben wird, wie sie in Figur 5 dargestellt ist. Wie des weiteren in Figur 5 zu erkennen ist, ist eine Nut 17 im Deckel 16 des elektrischen Gerätes 1 vorgesehen, in die der Klemmsteg 11 einrastet, so daß die plombierbare Verschließeinrichtung nicht ohne weiteres herausfallen kann oder nur unter Krafteinwirkung herausgezogen werden kann. Um das Herausziehen bzw. das erste Montieren und Eindrücken zu erleichtern, sind die Abschrägungen bzw. Abrundungen des Klemmstegs 11 vorgesehen. Der Schlitz 12 in dem Einsteckabschnitt 2 (siehe Figur 3) dient dazu, die Rastnasen 9 flexibel zu gestalten, so daß die Rastnasen etwas nach innen zusammengedrückt werden können. Dies ist bei der Montage der plombierbaren Verschließeinrichtung, das heißt beim Einschieben in die geschlossene Position hilfreich, da die Rastnasen 9 in Hinterschneidungen 10 im elektrischen Gerät 1 einrasten. Um einen lockeren Sitz der plombierbaren Verschließeinrichtung 20 mit zu viel Spiel zu vermeiden, ist ein Bereich vor der Hinterschneidung 10 am Ende der Einschuböffnung 4 vorgesehen, der so bemessen ist, daß der erste Berührpunkt mit der Rastnase 9 der plombierbaren Verschließeinrichtung 20 leicht überlappend ist. Das heißt, daß die Rastnasen beim weiteren Einschieben des Einsteckabschnitts 2 etwas nach innen in Richtung Schlitz 12 gedrückt werden. Sobald die Rastnasen die Hinterschneidung erreichen, schnappen sie aufgrund ihrer Vorspannung in die Hinterschneidung ein und somit ist die plombierbare Verschließeinrichtung gegen Herausziehen fixiert. Figur 6 zeigt in vergrößerter Darstellung die plombierbare Verschließeinrichtung im herausgezogenen Zustand, so daß die Hinterschneidung 10 in der Einschuböffnung 4 des elektrischen Gerätes 1 gut erkennbar ist. Figur 4 zeigt einen Zustand, in dem die plombierbare Verschließeinrichtung vollständig eingeschoben ist, das heißt, in dem die Rastnasen 9 in die Hinterschneidungen 10 eingegriffen haben und die plombierbare Verschließeinrichtung gegen Herausziehen gesichert ist. Figur 5 zeigt einen Zustand, in dem die plombierbare Verschließeinrichtung herausgezogen ist, wobei der Deckel 16 des elektrischen Gerätes nur zur Hälfte dargestellt ist, um dem Betrachter einen Einblick in die Einschuböffnung 4 zu geben. Anhand von Figur 5 ist ersichtlich, daß in dem dort gezeigten Zustand der Zugang zu der Klemmstelle 5 von oben her frei zugänglich ist.

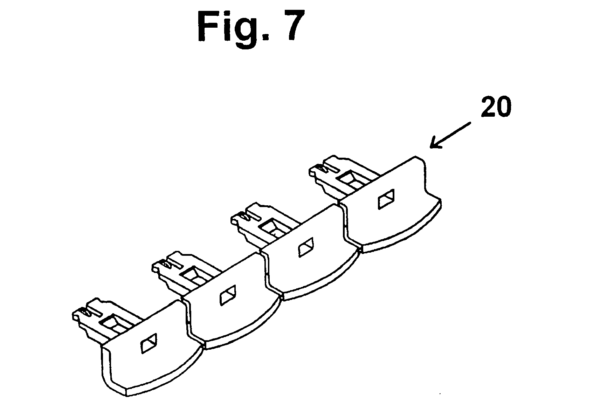

Figur 7 zeigt ein weiteres Ausführungsbeispiel der vorliegenden Erfindung, in dem mehrere plombierbare Verschließeinrichtungen nebeneinander angeordnet einstückig ausgebildet sind, wobei zwischen den einzelnen plombierbaren Verschließeinrichtungen lediglich dünne Sollbruchstellen die einzelnen plombierbaren Verschließeinrichtungen verbinden, so daß diese leicht getrennt werden können. Dies hat den Vorteil, daß die plombierbaren Verschließeinrichtungen beispielsweise in großeren Stuckzahlen dem Bedienungspersonal gegeben werden können, das dann individuell, je nach Bedarf, einzelne plombierbare Verschließeinrichtungen von der Reihe abtrennt und installiert. Selbstverständlich ist die Anzahl der einstückig ausgebildeten plombierbaren Verschließeinrichtungen nicht auf vier beschränkt, sondern kann in jeder beliebigen Anzahl hergestellt werden.

## Patentansprüche

1. Plombierbare Verschließeinrichtung (20) zum Verschließen einer elektrischen Betätigungseinrichtung eines elektrischen Geräts (1), die einen länglichen, in eine entsprechende Einschuböffnung (4) des elektrischen Geräts einschiebbaren Einsteckabschnitt (2) zum Verschließen eines Zugangs zu der elektrischen Betätigungseinrichtung und eine angeformte Handhabe mit einer Durchstecköffnung (3) zum Durchstecken eines Plombierdrahtes (6) aufweist, so dass die Verschließeinrichtung in einer die elektrische Betätigungseinrichtung verschließenden Stellung verplombbar ist, **dadurch gekennzeichnet, dass** der Einsteckabschnitt (2) auf einer Seite einen nutartigen Kanal (7) aufweist, der in der Durchstecköffnung (3) endet und durch den ein Ende des Plombierdrahts (6) in das elektrische Gerät (1) einführbar ist, wobei das zweite Ende über eine weitere Öffnung (19) aus dem Gerät herausführbar ist, um einen Deckel (16) des Geräts zu umgreifen und mit dem anderen Ende des Plombierdrahts (6) verbunden zu werden.

2. Plombierbare Verschließeinrichtung gemäß Anspruch 1 **dadurch gekennzeichnet, daß** der Einsteckabschnitt (2) zumindest eine Rastnase (9) aufweist, mit dem die plombierbare Verschließeinrichtung im eingeschobenen Zustand in einem entsprechenden Einschnappabschnitt (13) des elektrischen Gerätes festklemmbar ist.

3. Plombierbare Verschließeinrichtung gemäß dem vorhergehenden Anspruch, **dadurch gekennzeichnet, daß** die Rastnase (9) quer zur Einschubrichtung ausgebildet ist und in den Einschnappabschnitt (13) flexibel einschnappbar ist, der eine entsprechend geformte Hinterschneidung (10) aufweist.

4. Plombierbare Verschließeinrichtung gemäß einem der vorangehenden Ansprüche, **dadurch gekennzeichnet, daß** die plombierbare Verschließeinrichtung mindestens einen Klemmsteg (11) hat, der am Einsteckabschnitt (2) vorgesehen ist und senkrecht zur Einschubrichtung vorsteht.

5. Plombierbare Verschließeinrichtung gemäß einem der vorangehenden Ansprüche, **dadurch gekennzeichnet, daß** der Einsteckabschnitt (2) am Ende in der Mitte einen Schlitz (12) aufweist.

6. Plombierbare Verschließeinrichtung gemäß einem der vorangehenden Ansprüche, **dadurch gekennzeichnet, daß** der nutartige Kanal (7) an seinem Anfang angeschrägt oder gekrümmt ausgebildet ist.

7. Elektrisches Gerät wie ein Leistungsschutzschalter oder dergleichen mit einer Zugangsöffnung (19) zu einer Betätigungseinrichtung und einer bis zur Zugangsöffnung (19) durchgehenden, sich im wesentlichen quer dazu erstreckenden Einschuböffnung (4) zum Einschieben einer plombierbaren Verschließeinrichtung gemäß einem der Ansprüche 1 bis 6.

8. Elektrisches Gerät gemäß dem vorhergehenden Anspruch, **dadurch gekennzeichnet, daß** die Einschuböffnung (4) einen Einschnappabschnitt (13) aufweist, in den eine Rastnase (9) der plombierbaren Verschließeinrichtung im vollständig eingeschobenen Zustand einrastbar ist.

9. Elektrisches Gerät gemäß dem vorhergehenden Anspruch, **dadurch gekennzeichnet, daß** der Einschnappabschnitt (13) eine Hinterschneidung (10) aufweist.

10. Elektrisches Gerät gemäß einem der vorhergehenden Ansprüche 7 bis 9, **dadurch gekennzeichnet, daß** das elektrische Gerät ein Hauptgehäuseteil (15) und einen Deckel (16) aufweist.

11. Elektrisches Gerät gemäß dem vorhergehenden Anspruch, **dadurch gekennzeichnet, daß** die Einschuböffnung (4) zwischen Deckel (16) und Hauptgehäuseteil (15) ausgebildet ist.

12. Elektrisches Gerät gemaß einem der vorhergehenden Anspruche 7 bis 11, **dadurch gekennzeichnet, daß** in der Einschuböffnung (4) eine quer zur Einschubrichtung verlaufende Nut (17) vorgesehen ist.

13. Elektrisches Gerät gemäß einem der vorhergehenden Ansprüche 7 bis 12, **dadurch gekennzeichnet, daß** die Betätigungseinrichtung eine Klemmschraube für eine elektrische Klemmstelle (5) ist, zum manuellen Lösen bzw. Festklemmen eines elektrischen Leiters.

14. System bestehend aus einer plombierbaren Verschließeinrichtung (20) gemäß einem der vorangehenden Ansprüche 1 bis 6 und einem elektrischen Gerät (1) wie einem Leistungsschutzschalter oder dergleichen gemäß einem der vorangehenden Ansprüche 7 bis 13.

## Claims

1. Lead-sealable locking device (20) for locking an electrical operating apparatus of an electrical device (1) which possesses a longitudinal plug-in section (2) for closing access to the operating apparatus which can be pushed into a corresponding slot-in opening (4) of the electrical device and a moulded handle with an insertion opening (3) for insertion of a sealing wire (6), so that the locking device can be lead-sealed in a position locking the operating apparatus, **characterised in that** the plug-in section (2) possesses on one side a groove-like channel (7) which ends in the insertion opening (3) and through which one end of the sealing wire (6) can be introduced into the electrical device (1), whereby the second end can be passed out of the device via a further opening (19) so as to enclose a cover (16) of the device and be connected with the other end of the sealing wire (6).

2. Lead-sealable locking device in accordance with claim 1, **characterised in that** the plug-in section (2) possesses at least one snap lug (9) by means of which the lead-sealable locking device can, when slotted into place, be clamped into a corresponding snap-in section (13) of the electrical device.

3. Lead-sealable locking device in accordance with the preceding claim, **characterised in that** the snap lug (9) is formed transversely to the direction of insertion and can be snapped flexibly into the snap-in section (13), which possesses a correspondingly moulded undercut (10).

4. Lead-sealable locking device in accordance with one of the preceding claims, **characterised in that** the lead-sealable locking device has at least one clamping web (11) which is provided on the plug-in section (2) and which projects perpendicular to the direction of insertion.

5. Lead-sealable locking device in accordance with one of the preceding claims, **characterised in that** the plug-in section (2) possesses a slit (12) in the centre at its end.

6. Lead-sealable locking device in accordance with one of the preceding claims, **characterised in that** the groove-like channel (7) is bevelled or curved at its beginning.

7. Electrical device such as a circuit breaker or similar with an access opening (19) to an operating apparatus and a slot-in opening (4) extending through to the access opening (19) and aligned substantially at right angles to this for insertion of a lead-sealable locking device in accordance with one of claims 1 to 6.

8. Electrical device in accordance with the preceding claim, **characterised in that** the slot-in opening (4) possesses a snap-in section (13) into which a snap lug (9) of the lead-sealable locking device can be snapped when the locking device is slotted completely into place.

9. Electrical device in accordance with the preceding claim, **characterised in that** the snap-in section (13) possesses an undercut (10).

10. Electrical device in accordance with one of the preceding claims 7 to 9, **characterised in that** the electrical device possesses a main housing section (15) and a cover (16).

11. Electrical device in accordance with one of the preceding claims, **characterised in that** the slot-in opening (4) is formed between the cover (16) and the main housing section (15).

12. Electrical device in accordance with one of the preceding claims 7 to 11, **characterised in that** a groove (17) is provided in the slot-in opening (4) running transversely to the direction of insertion.

13. Electrical device in accordance with one of the preceding claims 7 to 12, **characterised in that** the operating apparatus is a clamping screw for an electrical terminal (5) for the manual detachment or clamping in place of an electrical conductor.

14. System consisting of a lead-sealable locking device (20) in accordance with one of the preceding claims 1 to 6 and an electrical device (1) such as a circuit breaker or similar in accordance with one of the preceding claims 7 to 13.

## Revendications

1. Dispositif de fermeture plombable (20) pour fermer un dispositif d'actionnement électrique d'un appareil électrique (1), comprenant une portion d'insertion allongée (2), enfichable dans une ouverture d'enfichage correspondante (4) pour fermer un accès au dispositif d'actionnement électrique, et un moyen de manipulation surmoulé pourvu d'une ouverture de passage (3) pour passer un fil de plombage (6), de sorte que le dispositif de fermeture peut être plombé dans une position fermant le dispositif d'actionnement électrique, **caractérisé en ce que** la portion d'insertion (2) est pourvue, sur un côté, d'un canal en forme de rainure (7) qui débouche dans l'ouverture de passage (3) et à travers lequel une extrémité du fil de plombage (6) peut être introduite dans l'appareil électrique (1), la seconde extrémité ressortant de l'appareil à travers une autre ouverture (19) afin d'entourer un couvercle (16) de l'appareil et d'être reliée à l'autre extrémité du fil de plombage (6).

2. Dispositif de fermeture plombable selon la revendication 1, **caractérisé en ce que** la portion d'insertion (2) comporte au moins un talon d'encliquetage (9) permettant de bloquer le dispositif de fermeture plombable à l'état enfiché dans une portion d'emboîtement correspondante (13) de l'appareil électrique.

3. Dispositif de fermeture plombable selon la revendication précédente, **caractérisé en ce que** le talon d'encliquetage (9) est conformé transversalement à la direction d'enfichage et peut être emboîté de manière souple dans la portion d'emboîtement (13), laquelle comporte une contre-dépouille de forme correspondante (10).

4. Dispositif de fermeture plombable selon une des revendications précédentes, **caractérisé en ce que** le dispositif de fermeture plombable possède au moins une patte de serrage (11) qui est disposée sur la portion d'emboîtement (2) et fait saillie perpendiculairement à la direction d'enfichage.

5. Dispositif de fermeture plombable selon une des revendications précédentes, **caractérisé en ce que** la portion d'emboîtement (2) comporte une fente (12) au centre de son extrémité.

6. Dispositif de fermeture plombable selon une des revendications précédentes, **caractérisé en ce que**, à son amorce, le canal en forme de rainure (7) présente une conformation biseautée ou courbe.

7. Appareil électrique, tel qu'un disjoncteur de protection de circuit ou analogue, pourvu d'une ouverture d'accès (19) à un dispositif d'actionnement et d'une ouverture d'enfichage (4) qui communique avec l'ouverture d'accès (19) et s'étend sensiblement transversalement à celle-ci afin d'enficher un dispositif de fermeture plombable selon une des revendications 1 à 6.

8. Appareil électrique selon la revendication précédente, **caractérisé en ce que** l'ouverture d'enfichage (4) comporte une portion d'emboîtement (13) dans laquelle, à l'état complètement enfiché, un talon d'encliquetage (9) du dispositif de fermeture plombable peut s'encliqueter.

9. Appareil électrique selon la revendication précédente, **caractérisé en ce que** la portion d'emboîtement (13) comporte une contre-dépouille (10).

10. Appareil électrique selon une des revendications précédentes 7 à 9, **caractérisé en ce que** l'appareil électrique comporte une partie principale de boîtier (15) et un couvercle (16).

11. Appareil électrique selon la revendication précédente, **caractérisé en ce que** l'ouverture d'enfichage (4) est ménagée entre le couvercle (16) et la partie principale de boîtier (15).

12. Appareil électrique selon une des revendications précédentes 7 à 11, **caractérisé en ce qu'**une rainure (17) s'étendant transversalement à la direction d'enfichage est prévue dans l'ouverture d'enfichage (4).

13. Appareil électrique selon une des revendications précédentes 7 à 12, **caractérisé en ce que** le dispositif d'actionnement est une vis de serrage pour un point de serrage électrique (5) destiné à desserrer, respectivement bloquer manuellement un conducteur électrique.

14. Système constitué d'un dispositif de fermeture plombable (20) selon une des revendications précédentes 1 à 6 et d'un appareil électrique (1) tel qu'un disjoncteur de protection de circuit ou analogue selon une des revendications précédentes 7 à 13.
